# EUROPÄISCHE PATENTSCHRIFT

(11) **EP 1 020 894 B1**
(45) Veröffentlichungstag und Bekanntmachung des Hinweises auf die Patenterteilung: **20.08.2008**
(21) Anmeldenummer: 99125780.9
(22) Anmeldetag: 23.12.1999
(51) Int. Cl.: H01L 21/00, H01L 21/68

(54) **Vorrichtung zur Ätzbehandlung eines scheibenförmigen Gegenstandes**
Device for etching a disk-like object
Dispositif d'attaque chimique d'un objet en forme de disque

(30) Priorität: 15.01.1999 DE 19901291
(43) Veröffentlichungstag der Anmeldung: 19.07.2000
(73) Patentinhaber: SEZ AG, 9500 Villach (AT)
(72) Erfinder: Langen, Kurt, DI. (FH), A-9500 Villach (AT); Engesser, Phillipp, 88131 Lindau (DE)
(74) Vertreter: Kontrus, Gerhard

(56) Entgegenhaltungen:
- EP-A- 0 611 274
- WO-A-98/32893
- PATENT ABSTRACTS OF JAPAN Bd. 0040, Nr. 97 (E-018), 12. Juli 1980 (1980-07-12) -& JP 55 059724 A (HITACHI LTD), 6. Mai 1980 (1980-05-06)

## Beschreibung

Die Erfindung betrifft eine Vorrichtung zur Ätzbehandlung eines scneibenförmigen Gegenstandes, insbesondere eines Wafers, mit einer Einrichtung zur berührungslosen Aufnahme des scheibenförmigen Gegenstandes und mindestens zwei, senkrecht zur Einrichtung angeordneten, die Position des scheibenförmigen Gegenstandes umfangsseitig begrenzenden Führungselementen.

Eine solche Vorrichtung ist beispielsweise aus der EP 0 611 274 A1 bekannt.

Dabei wird der Wafer berührungslos (auf einem Luftpolster) auf einem zugehörigen Träger der Einrichtung positioniert und während der Behandlung gedreht. Solche, nach dem Bernoulli-Prinzip arbeitenden Vorrichtungen zur Waferbehandlung haben sich grundsätzlich bewährt. Die berührungslose "Auflage" des Wafers auf der Einrichtung verhindert, daß die der Einrichtung zugewandte Unterseite bei der Behandlung beschädigt wird.

Der Wafer hat allenfalls Kontakt zu seitlichen Führungselementen (oft auch pins genannt), die gemäß der EP 0 611 274 A1 exzentrisch gelagert sind.

Insbesondere bei der Ätzbehandlung hat sich herausgestellt, daß die Ätzflüssigkeit im Kantenbereich des Wafers auf die Unterseite laufen kann, und zwar insbesondere im Bereich dieser pins. Die Folge ist, daß auch die Unterseite des Wafers im Pinbereich geätzte Abschnitte aufweist, sogenannte pinmarks.

Dieses Problem wird in der JP 9-107023 A angesprochen und dahingehend gelöst, daß einzelne pins während der Waferbehandlung nach und nach von der Waferkante temporär gelöst (weggeführt) werden. Eine solche Einrichtung erfordert jedoch einerseits einen erheblichen apparativen und steuerungstechnischen Aufbau und weist darüber hinaus den Nachteil auf, daß mehr pins vorgesehen werden müssen als eigentlich zur seitlichen Führung des Wafers benötigt werden, damit auch bei einem oder zwei weggeführten pins der Wafer nach wie vor exakt positioniert bleibt.

Insoweit liegt der Erfindung die Aufgabe zugrunde, das in der japanischen Offenlegungsschrift angesprochene und vorstehend genannte Problem auf alternativem Wege zu lösen. Insbesondere geht es darum, die im Bereich der seitlichen Führungselemente unterseitig beobachteten Ätzflächen zu vermeiden.

Dabei geht die Erfindung von der Überlegung aus, durch eine gezielte (zusätzliche) Gasanströmung zu verhindern, daß eine Ätzflüssigkeit oder ein sonstiges Behandlungsmedium über die Waferkante auf die Unterseite des Wafers gelangt, und zwar gezielt im Bereich der Führungselemente für den Wafer.

Danach schlägt die Erfindung in ihrer allgemeinsten Ausführungsform eine Vorrichtung der eingangs genannten Art vor, bei der jedem Führungselement mindestens eine Bedüsungseinrichtung zugeordnet ist, über die ein gasförmiges Behandlungsmedium gegen die Unterseite des scheibenförmigen Gegenstandes unmittelbar benachbart zum jeweiligen Führungselement leitbar ist.

Mit anderen Worten: jedem Führungselement wird eine eigene Düse zugeordnet, über die ein Gas unter Druck gezielt von unten in den Bereich des zugehörigen Führungselementes gedüst wird. Auf diese Weise wird die Behandlungsflüssigkeit weggeblasen, bevor sie auf die nicht zu ätzenden Bereiche der Wafer-Unterseite gelangen kann und eine unerwünschte Behandlung der Wafer-Unterseite verhindert.

Die Effektivität der Bedüsungseinrichtung kann gesteigert werden, wenn sie so ausgerichtet ist, daß das zugehörige gasförmige Behandlungsmedium das zugehörige Führungselement zumindest innenseitig umspült. Bei dieser Ausführungsform verläuft das Austrittsende der Bedüsungseinrichtung also unterhalb des Wafers und vorzugsweise in einem Winkel > 1 und < 90° zur Ebene des Wafers. Dabei haben sich Winkel zwischen 10 und 60° als günstig herausgestellt.

Die schräge Luftandüsung stellt sicher, daß etwaige Flüssigkeit radial nach außen weggeblasen wird, bevor sie in diesem Bereich um die Waferkante auf die Unterseite des Wafers gelangen kann.

Eine Ausführungsform sieht vor, daß die Bedüsungseinrichtungen jeweils mindestens einen Gaszufuhrkanal auf-weisen, der innerhalb eines durch die Führungselemente eingeschlossenen gedachten Flächenabschnitts angeordnet ist.

Dabei wird als Träger bei einer nach dem Bernoulli-Prinzip arbeitenden Vorrichtung die Fläche definiert, die innerhalb der Bedüsungseinrichtung verläuft, die der berührungsfreien Führung des Wafers dient.

Die Form der Bedüsungseinrichtung, insbesondere die Querschnittsform eines zugehörigen Gaszuführkanals, richtet sich insbesondere nach der konstruktiven Gestaltung der Führungselemente (pins). Bei zylindrischen pins wird der Gaszuführkanal einen Kreisquerschnitt aufweisen oder schlitzförmig sein und die Querschnittsfläche so bemessen, daß zumindest der Bereich der Waferunterseite benachbart zum Führungselement zusätzlich und flächig bedüst werden kann. Die Teilung des Gasführkanals in einzelne Teilkanäle ist ebenfalls möglich.

Dabei kann jede Bedüsungseinrichtung außerhalb und mit Abstand zu einem Bereich angeordnet sein, über den ein Gaspolster nach dem Bernoulli-Prinzip zwischen dem Träger und dem scheibenförmigen Gegenstand aufgebaut wird.

In Vorversuchen wurde festgestellt, daß die über die Bedüsungseinrichtung zugeführte Menge an gasförmigem Behandlungsmedium mindestens 10 % der Gesamtmenge an gasförmigem Behandlungsmedium betragen sollte, die gegen die Unterseite des scheibenförmigen Gegenstandes strömt. Die Gesamtmenge schließt demnach auch die Gasmenge ein, die notwendig ist, um den Wafer kontaktfrei im Abstand auf der Einrichtung zu führen.

Hinsichtlich der Geometrie und Anzahl der Führungselemente unterliegt die erfindungsgemäße Vorrichtung keinen Beschränkungen. Prinzipiell genügt es demnach, zwei Führungselemente vorzusehen, die dann beispielsweise jeweils eine Kreisabschnittform aufweisen. Hierbei entsteht zwangsläufig ein gewisser Linien- oder Flächenkontakt zur Kante des Wafers, der verringert werden kann, wenn beispielsweise zylindrische Führungselemente (Stifte) verwendet werden, von denen dann mindestens drei vorzusehen sind.

In jedem Fall können die Führungselemente - wie aus der EP 0 611 274 A1 bekannt - wiederum in mindestens zwei unterschiedlichen Positionen, relativ zum scheibenförmigen Gegenstand, positioniert werden.

Mit der erfindungsgemäßen Vorrichtung wird jede "Unterätzung" im Bereich der Führungselemente durch die genannten Bedüsungseinrichtungen verhindert. Ein zusätzlicher steuerungstechnischer Aufwand entsteht dadurch nicht, da das gleiche Behandlungsmedium auch zur Einstellung des Bernoulli-Effektes (zur Führung des Wafers) verwendet werden kann.

Die erfindungsgemäße Lehre ist so aufgebaut, daß auch bekannte Vorrichtungen beispielsweise gemäß der EP 0 611 274 A1 erfindungsgemäß nachgerüstet werden können. Hierzu ist es lediglich notwendig, im Bereich der pins (Führungselemente) zusätzliche Bohrungen vorzusehen, über die das Gas unter Druck gegen die pins und die benachbarte Wafer-Unterseite gedüst wird. Dieser Druck kann höher sein als der Gasdruck zur berührungslosen Führung des Wafers.

Die Erfindung wird nachstehend anhand eines Ausführungsbeispieles näher beschrieben, welches - in schematisierter Darstellung - einen Teilschnitt durch eine erfindungsgemäße Vorrichtung zeigt.

Zu erkennen ist dabei ein Träger 10 als Bestandteil einer Einrichtung 12 mit einer ringförmigen Düse 14, über die ein Gas in Pfeilrichtung P gedüst wird. Auf diese Weise wird sichergestellt, daß ein auf dem Träger 10 (der Einrichtung 12) angeordneter Wafer 16 sicher im Abstand zur Trägeroberfläche 10o geführt wird, wobei die eigentliche "Führung" über seitliche pins 18 erfolgt, die senkrecht aus der Aufnahme 12 vorstehen. Die pins 18 sind exzentrisch geführt und berühren in der Betriebsposition die zugehörige Kante des Wafers 16 entsprechend punkt- oder linienförmig.

Benachbart zur Düse 14 ist in der Aufnahme 12 ein Gaszuführungskanal 20 angeordnet, der unter einem Winkel a von etwa 45° zur Trägeroberfläche 10o verläuft und so ausgerichtet ist, daß ein über den Kanal 20 zugeführtes Gas gegen einen zugehörigen pin 18 beziehungsweise dessen benachbarten Abschnitt der Unterseite 16u des Wafers 16 gedüst wird. Mit anderen Worten: die Mittenlängsachse des Kanals 20 und des pins 18 liegen in einer Ebene. Auf diese Weise wird zuverlässig verhindert, daß etwaige Ätzflüssigkeit auf den Flächenabschnitt 16u des Wafers 16 gelangt und dort unerwünschte Ätzungen (sogenannte pinmarks) erfolgen.

Im dargestellten Ausführungsbeispiel beträgt die Gasmenge, die durch den Kanal 20 strömt, ca. 2 Volumen-Einheiten je Minute, während die Gasmenge, die durch die Düse 14 strömt, ca. 8 Volumen-Einheiten je Minute umfaßt.

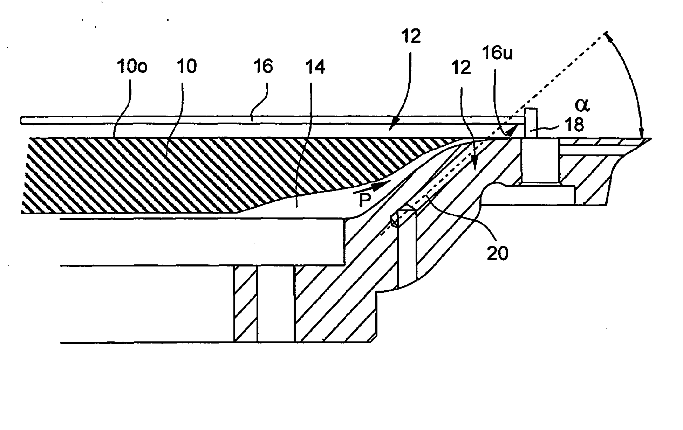

## Patentansprüche

1. Vorrichtung zur Ätzbehandlung mit Atzflüssigkeiten eines scheibenförmigen Gegenstandes (16), insbesondere eines Wafers, mit einer Einrichtung (12) zur berührungslosen Aufnahme des scheibenförmigen Gegenstandes (16) und mindestens zwei, senkrecht zur Einrichtung (12) angeordneten, die Position des scheibenförmigen Gegenstandes (16) umfangsseitig begrenzenden Führungselementen (18), **dadurch gekennzeichnet, daß** jedem Führungselement (18) mindestens eine Bedüsungseinrichtung (20) zugeordnet ist, über die ein gasförmiges Behandlungsmedium gegen die Unterseite (16u) des scheibenförmigen Gegenstandes (16) unmittelbar benachbart zum jeweiligen Führungselement (18) leitbar ist.

2. Vorrichtung nach Anspruch 1, bei der jede Bedüsungseinrichtung (20) einen innerhalb eines durch die Führungselemente (18) eingeschlossenen gedachten Flächenabschnitts verlaufenden Gaszuführkanal umfaßt.

3. Vorrichtung nach Anspruch 1, bei der jede Bedüsungseinrichtung (20) unter einem Winkel > 1 und < 90° zur Ebene des scheibenförmigen Gegenstandes (16) ausgerichtet ist.

4. Vorrichtung nach Anspruch 3, bei der jede Bedüsungseinrichtung (20) unter einem Winkel > 10 und < 60° zur Ebene des scheibenförmigen Gegenstandes (16) ausgerichtet ist.

5. Vorrichtung nach Anspruch 1, bei der jede Bedüsungseinrichtung (20) außerhalb und mit Abstand zu einem Bereich angeordnet ist, über den ein Gaspolster nach dem Bernoulli-Prinzip zwischen der Einrichtung (12) und dem scheibenförmigen Gegenstand (16) aufgebaut wird.

6. Vorrichtung nach Anspruch 1, bei der jede Bedüsungseinrichtung (20) so ausgerichtet ist, daß das zugehörige gasförmige Behandlungsmedium das zugehörige Führungselement (18) zumindest innenseitig umspült.

7. Vorrichtung nach Anspruch 1, bei der die über die Bedüsungseinrichtungen (20) zugeführte Menge an gasförmigem Behandlungsmedium mindestens 10 % der Gesamtmenge am gasförmigen Behandlungsmedium beträgt, die gegen die Unterseite des scheibenförmigen Gegenstandes (16) strömt.

8. Vorrichtung nach Anspruch 1, bei der jedes Führungselement (18) in mindestens zwei unterschiedlichen Positionen, relativ zum scheibenförmigen Gegenstand (16), positionierbar ist.

## Claims

1. A device for etching treatment using etching liquids of a disc-shaped object (16), in particular a wafer, having a unit (12) for contactless accommodation of the disc-shaped object (16) and having at least two guide elements (18) situated perpendicular to the unit (12) and delimiting the position of the disc-shaped object (16) around its circumference, **characterized in that** at least one spray unit (20) is assigned to each guide element (18), via which a gaseous treatment medium may be conducted against the bottom side (16u) of the disc-shaped object (16) directly adjacent to the particular guide element (18).

2. The device according to Claim 1, wherein each spray unit (20) comprises a gas supply channel running within an imaginary area section enclosed by the guide elements (18).

3. The device according to Claim 1, wherein each spray unit (20) is oriented at an angle > 1 and < 90° to the plane of the disc-shaped object (16).

4. The device according to Claim 3, wherein each spray unit (20) is oriented at an angle > 10 and < 60° to the plane of the disc-shaped object (16).

5. The device according to Claim 1, wherein each spray unit (20) is situated outside and at a distance to an area over which a gas cushion is built up between the unit (12) and the disc-shaped object (16) according to the Bernoulli principle.

6. The device according to Claim 1, wherein each spray unit (20) is oriented in such a manner that the associated gaseous treatment medium washes around the associated guide element (18) at least on the interior.

7. The device according to Claim 1, wherein the quantity of gaseous treatment medium supplied via the spray units (20) is at least 10% of the total quantity of gaseous treatment medium which flows against the bottom side of the disc-shaped object (16).

8. The device according to Claim 1, wherein each guide element (18) is positionable in at least two different positions in relation to the disc-shaped object (16).

## Revendications

1. Dispositif pour un traitement par attaque chimique avec des liquides d'attaque chimique sur un objet en forme de plaque (16), en particulier une plaquette de silicium, avec un dispositif (12) pour recevoir sans contact l'objet en forme de plaque (16) et au moins deux éléments de guidage (18) disposés perpendiculairement au dispositif (12) et limitant sur la circonférence la position de l'objet en forme de plaque (16), **caractérisé en ce que** chaque élément de guidage (18) est associé à au moins un dispositif de projection (20) par lequel un produit de traitement gazeux peut être amené vers la face inférieure (16u) de l'objet en forme de plaque (16) juste à côté de l'élément de guidage (18) correspondant.

2. Dispositif selon la revendication 1, dans lequel chaque dispositif de projection (20) comprend un canal d'arrivée de gaz passant à l'intérieur d'une partie de surface imaginaire délimitée par les éléments de guidage (18).

3. Dispositif selon la revendication 1, dans lequel chaque dispositif de projection (20) est orienté selon un angle > 1° est < 90° par rapport au plan de l'objet en forme de plaque (16).

4. Dispositif selon la revendication 3, dans lequel chaque dispositif de projection (20) est orienté selon un angle > 10° et < 60° par rapport au plan de l'objet en forme de plaque (16).

5. Dispositif selon la revendication 1, dans lequel chaque dispositif de projection (20) est disposé en dehors et à distance d'une zone dans laquelle un coussin de gaz est constitué selon le principe de Bernoulli entre le dispositif (12) et l'objet en forme de plaque (16).

6. Dispositif selon la revendication 1, dans lequel chaque dispositif de projection (20) est orienté de telle manière que le produit de traitement gazeux correspondant irrigue le l'élément de guidage (18) au moins sur sa face intérieure.

7. Dispositif selon la revendication 1, dans lequel la quantité de produit de traitement gazeux amenée par les dispositifs de projection (20) est d'au moins 10 % de la quantité totale de produit de traitement qui circule vers la face inférieure de l'objet en forme de plaque (16).

8. Dispositif selon la revendication 1, dans lequel chaque élément de guidage (18) peut être positionné dans au moins deux positions différentes par rapport à l'objet en forme de plaque (16).
